# FASCICULE DE BREVET EUROPEEN

(11) **EP 2 564 412 B1**
(45) Date de publication et mention de la délivrance du brevet: **14.03.2018**
(21) Numéro de dépôt: 11716268.5
(22) Date de dépôt: 27.04.2011
(51) Int. Cl.: H01J 37/32, H05H 1/24

(54) **ELECTRODE POUR PROCEDE PLASMA DBD**
ELEKTRODE FÜR PLASMA-DBD-VERFAHREN
ELECTRODE FOR DBD PLASMA PROCESS

(30) Priorité: 30.04.2010 EP 10161557
(43) Date de publication de la demande: 06.03.2013
(73) Titulaire: AGC Glass Europe, 1348 Louvain-la-Neuve (BE)
(72) Inventeur: TIXHON, Eric, B-6040 Jumet (BE); MICHEL, Eric, B-6040 Jumet (BE); LECLERCQ, Joseph, B-5600 Philippeville (BE)
(74) Mandataire: Agustsson, Sveinn Otto
(86) Numéro de dépôt international: PCT/EP2011/056621
(87) Numéro de publication internationale: WO 2011/134978

(56) Documents cités:
- WO-A1-02/35576
- US-A1- 2005 179 395
- US-A1- 2006 196 424
- US-A1- 2007 108 910
- US-A1- 2008 179 286
- 'COEFFICIENT OF THERMAL EXPANSION FOR VARIOUS MATERIALS AT DIFFERENT TEMPERATURES CONTENTS', [en ligne] 15 Juin 2005, XP055188719 Extrait de l'Internet: <URL:http://www.balseal.com/sites/default/f iles/tr18_020707131421.pdf> [extrait le 2015-05-12]

## Description

L'invention se rapporte à un dispositif (ou installation) comprenant des électrodes destinées à être utilisées dans le cadre du traitement et/ou la préparation de surfaces par procédé incorporant une décharge à barrière diélectrique (DBD), et particulièrement pour le revêtement de volumes de verre dans le cas notamment de production continue.

L'invention se rapporte aussi à une méthode de fabrication d'une telle électrode dans ce dispositif et à une telle électrode.

Le traitement de surface par plasma est bien connu notamment dans le domaine verrier, mais également dans le domaine des films plastiques. Il consiste à engendrer un plasma entre au moins deux électrodes, et à injecter dans ce plasma des produits précurseurs donnant lieu à l'apparition, par réaction et/ou ionisation, à des réactifs agissant sur les surfaces à traiter.

Le problème est que les électrodes sont soumises à des conditions de travail très sévères : température élevée du plasma, haute réactivité des produits injectés et/ou engendrés, conditions de tension, de courant et de fréquence propres à entraîner des forces électrostatiques et l'apparition d'arcs à la surface de l'électrode pouvant amener des claquages localisés voire la destruction pure et simple de l'électrode.

Ces problèmes sont encore plus prégnants dans le cas d'électrodes placées dans des lignes de production de surfaces de grandes dimensions, tels que des volumes de verre.

Une méthode connue pour réduire ces problèmes est de disposer une couche électriquement isolante sur la face de l'électrode mise en vis-à-vis de la surface à traiter.

Toutefois, la fabrication d'une telle électrode composite pose elle-même une série de problèmes techniques peu faciles à résoudre. Dans le cas d'électrodes cylindriques, le diélectrique peut être réalisé sous forme de manchon, ce qui résout géométriquement le problème de son maintien sur la surface de l'électrode. Cependant, la surface active suit une des génératrices du cylindre et elle est par conséquence très réduite, ce qui implique une vitesse de défilement relativement lente et/ou une multiplication des éléments d'électrodes.

Il n'en va pas de même dans le cas d'une électrode plane, surtout si elle est de grandes dimensions : on se trouve devant des surfaces planes qu'il y a lieu de solidariser autrement que par leur géométrie intrinsèque. Par ailleurs, le diélectrique et le matériau (généralement métallique) d'une électrode plane présentent des coefficients de dilatation souvent très différents, ce qui rend sa fabrication et son emploi délicats.

Différentes techniques peuvent être utilisées pour solidariser l'électrode et la couche diélectrique.

WO 2004/001790 et US 2005/0226802 utilisent un assemblage par collage. La nature de l'adhésif n'est pas renseignée. Dans le premier document, une des électrodes est poreuse. Dans le second, le contexte d'utilisation des électrodes est la production de substances chimiques. Dans WO 2007/038256, qui traite de nuisances olfactives, un treillis métallique est collé à un diélectrique au moyen d'un adhésif siliconé. Dans US 2006/0196424, le contact intime entre les parties métallique et diélectrique des électrodes est réalisé moyennant l'insertion d'un liquide conducteur d'électricité ou d'un polymère adhésif conducteur d'électricité.

Dans US 2007/0182327, l'assemblage est réalisé par anodisation. US 2005/0179395 fait appel à la pulvérisation. WO 00/718866 fait appel à un dépôt électrochimique. Un dépôt chimique en phase vapeur est évoqué dans US 6,692,704. US 6,692,704 utilise un revêtement par trempage.

US 2008/179286 A1 divulgue une description géométrique de la fabrication d'une électrode DBD sans mentionner la manière dont celle-ci est assemblée.

WO 02/35576 A1 concerne un dispositif de refroidissement d'électrode DBD, mais est silencieux sur une quelconque couche intercalaire polymérique.

Un premier but de l'invention est de réaliser une électrode plane de grandes dimensions pour les procédés DBD.

Un autre but de l'invention est que cette électrode présente une bonne durabilité.

Un autre but de l'invention est que cette électrode prévienne la formation d'arcs localisés.

Un autre but de l'invention est que cette électrode soit relativement facile à réaliser et d'un coût raisonnable.

Un premier objet de l'invention est une électrode plane selon la revendication 1. Avantageusement, une face interne de la partie active forme avec l'enveloppe métallique un échangeur de chaleur, lequel peut être adapté à être relié à un circuit de refroidissement dans lequel circule un fluide caloporteur ou réfrigérant ou encore dénommé fluide de refroidissement.

Un autre objet de l'invention est un dispositif selon la revendication 10. Avantageusement, la couche polymérique intercalaire présente un taux d'allongement avant déchirure compatible avec un différentiel de coefficient linéaire d'expansion thermique compris, pour une gamme de température de 0 à 100°C, entre 0.01 10⁻⁶/°C et 1000.10⁻⁶/°C. Ceci permet une bonne adhérence entre la plaque du matériau diélectrique et la partie active de l'électrode et évite toute dégradation mécanique à chaud, tel que rupture ou cisaillement de l'un par rapport à l'autre.

Avantageusement, l'épaisseur de cette couche est comprise entre 0,3 et 0,7 mm, car cette couche nécessite une épaisseur pour permettre de reprendre les variations dimensionnelles de la plaque du matériau diélectrique et de la partie active.

Suivant une forme de réalisation préférée, la couche intercalaire est du PVB [poly(butyral de vinyl)].

Suivant une forme de réalisation préférée, le fluide réfrigérant est de l'eau.

Cette eau est de préférence faiblement minéralisée de façon à constituer un fluide de faible conductivité.

L'électrode est très avantageusement réalisée en un matériau présentant à la fois un bon coefficient de conductivité électrique et un bon coefficient de conductibilité thermique. Typiquement, l'enveloppe métallique est réalisée en un matériau présentant à la fois un coefficient de conductivité électrique compris entre 1 et 80 m/(Ωmm²) et un coefficient de conductibilité thermique compris 50 et 400 W/(mK).

Le matériau métallique est de façon avantageuse du cuivre.

La couche diélectrique est formée par exemple par une plaque d'alumine, de quartz ou de vitrocéramique, ou autre matériau approprié présentant des fonctionnalités identiques.

De préférence, dans le dispositif, l'électrode est reliée à deux circuits de refroidissements primaires et secondaires munis respectivement d'un premier et d'un deuxième échangeurs de chaleur. Le second échangeur de chaleur relie le circuit de refroidissement primaire au circuit de refroidissement secondaire par l'intermédiaire de conduits en matériau à faible conductivité électrique, la longueur et la section de ces conduits étant calculées de telle manière que ces conduits constituent une résistance d'isolement suffisante pour que ce second échangeur de chaleur puisse être mis à la terre en n'engendrant qu'un courant de fuite négligeable. Un avantage de ce mode de réalisation est que toute intervention sur le circuit de refroidissement peut être faite sans affecter la sécurité du personnel.

Suivant un mode de réalisation avantageux, les conduits aller et retour du circuit de refroidissement secondaire sont enroulés sur un tambour. Un avantage de ce mode de réalisation est que, quelle que soit la longueur du conduit, le système réfrigérant occupe une place au sol réduite. De préférence, les conduits aller et retour du circuit de refroidissement secondaire sont placés côte à côte sur le tambour.

Le circuit de refroidissement secondaire peut comprendre en outre un système de contrôle mesurant périodiquement la conductivité du fluide de refroidissement.

Les modes préférentiels et avantageux d'un tel dispositif sont ceux décrits plus haut pour l'électrode.

Un autre aspect de l'invention est une méthode de fabrication d'une électrode plane pour traitement plasma DBD de surfaces telle que définie plus haut, comprenant les opérations suivantes de :
a) Fabrication d'une enveloppe métallique apte à être portée à haute tension, cette enveloppe comprenant une partie extérieure plane et un volume intérieur apte à y faire circuler un fluide de refroidissement ;
b) Pose d'une feuille de polymère sur la face extérieure de la partie plane;
c) Positionnement d'une plaque de matériau diélectrique sur cette couche de polymère,
d) Chauffage de l'électrode jusqu'à ramollissement de la feuille de polymère;
e) Mise sous dépression de l'ensemble de l'électrode ainsi constituée jusqu'à disparition de bulles éventuelles;
f) Mise sous pression de l'ensemble de l'électrode ainsi constituée ;
g) Refroidissement progressif de l'électrode.

A l'étape a), cette enveloppe peut être fabriquée en plusieurs parties, assemblées suivant différentes méthodes connues de l'homme du métier.

A l'étape b), il y a enduction à chaud de la face (ou partie) extérieure de cette enveloppe plane par une couche polymérique. On peut également procéder par injection de polymère entre les deux surfaces prépositionnées.

La mise dans une enceinte sous dépression puis en surpression de l'électrode ainsi constituée aux étapes e) et f) présentent l'avantage d'éviter la formation de bulles d'air susceptibles d'engendrer la formation localisée d'arcs électriques ;
Suivant une forme de réalisation avantageuse, la couche polymérique est constituée de poly(butyral de vinyl)(en abrégé PVB).

Un avantage de l'invention est que le PVB, bien que ne résistant pas à de très hautes températures, permet d'absorber le différentiel très important d'allongement dû à la différence entre les coefficients de dilatation thermique de la partie active et du matériau diélectrique.

Ces aspects ainsi que d'autres aspects de l'invention sont illustrés dans la description détaillée de modes de réalisation particuliers de l'invention, référence étant faite aux dessins des figures, dans lesquelles :
Fig.1 est une vue en coupe, en perspective cavalière avec interruption de l'électrode suivant l'invention ;
Fig.2 est une vue en perspective en coupe de l'enrouleur d'alimentation de l'électrode de la Fig. 1 ;
La Fig. 3 est une vue schématique en coupe suivant le plan III-III de l'enrouleur de la Fig. 2 ;
La Fig. 4 est une vue schématique de l'électrode dans son ensemble comportant deux circuits de refroidissement.

Les figures ne sont pas dessinées à l'échelle (les épaisseurs, notamment, sont exagérées pour faciliter la compréhension). Généralement, des éléments semblables sont dénotés par des références semblables dans les figures.

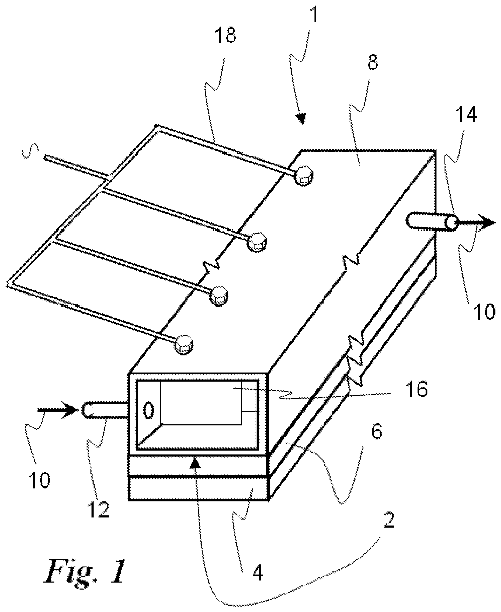

La Figure 1 est une représentation schématique de l'électrode de l'invention. Cette électrode 1 ayant été développée surtout pour les traitements de surface et/ou le revêtement de volumes de verre de grandes dimensions, peut faire typiquement près de quatre mètres de long, c'est pourquoi elle a été représentée avec interruption.

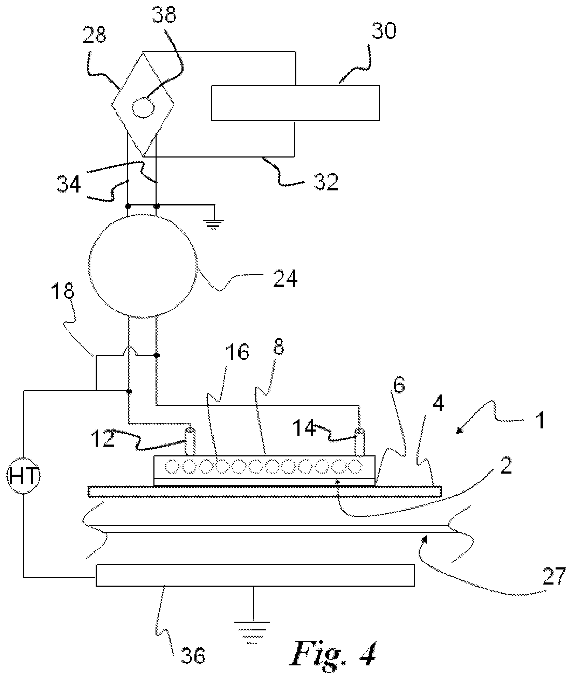

Cette électrode 1 est normalement montée en vis-à-vis d'une autre électrode, un plasma étant généré dans l'intervalle séparant ces deux éléments du fait de l'application d'un champ électrique HF à très haute tension entre les électrodes. La partie « active » de l'électrode, c'est-à-dire la partie orientée vers cette deuxième électrode 36 est une surface essentiellement plane 2 représentée ici orientée vers le bas (Fig. 4). Un des problèmes auxquels l'homme du métier se retrouve confronté est le risque d'apparition d'étincelles au sein des gaz ionisés. Celles-ci drainent un courant intense, entraînant non seulement des pertes d'énergie, mais aussi entraînent des défauts dans les surfaces à traiter et la dégradation des électrodes. Pour éviter ce phénomène, on dispose dans l'intervalle entre les électrodes une couche diélectrique 4, formée par exemple par une plaque d'alumine, de quartz ou de vitrocéramique, ou autre matériau approprié.

L'interposition d'une telle couche diélectrique 4, si elle résout le problème du claquage, entraîne cependant d'autres contraintes, comme la liaison entre la partie active 2 de l'électrode 1 et la couche diélectrique 4. Ces deux matériaux étant de natures difficilement compatibles, on a généralement recours à des techniques de collage extrêmement sophistiquées, généralement avec interposition de couches intermédiaires de matériaux divers, ce qui grève les coûts de fabrication d'une électrode. Par ailleurs, l'électrode est très avantageusement construite en un matériau excellent conducteur de l'électricité, pour réduire notamment les pertes par effet Joule, ce qui implique l'utilisation de métaux, tels que le cuivre, l'argent etc. Or ces métaux présentent généralement un coefficient de dilatation élevé, tout à l'opposé des matériaux diélectriques. La couche de liaison se trouve donc soumise à des effets de cisaillement importants.

On a donc songé à utiliser pour effectuer cette liaison, en lieu et place des techniques connues (soudure, revêtements moléculaires compatibles, collage pur et simple), une couche intercalaire 6. La recherche d'un matériau intercalaire approprié n'était pas cependant évidente.

Cet intercalaire 6 doit en effet permettre l'obtention d'un assemblage homogène, par exemple en évitant la formation de microbulles d'air susceptibles de créer des défauts d'isolation diélectrique, et doit respecter un parallélisme rigoureux entre les faces des matériaux à assembler.

L'intercalaire 6 doit présenter des propriétés d'adhérence permettant de maintenir ensemble les deux matériaux dans des conditions de sollicitation (température et pression) inhabituelles.

L'intercalaire 6 doit présenter un taux d'allongement important avant déchirure, afin de faire face aux sollicitations mécaniques produites par une différence de dilatation thermique des matériaux à assembler. Ce taux d'allongement sera donc compatible avec le différentiel de coefficient linéaire d'expansion thermique des matériaux à assembler, qui est généralement compris, pour une gamme de température de 0 à 100°C, entre 0.01 10⁻⁶/°C et 1000.10⁻⁶/°C, de façon préférentielle entre 0.1 10⁻⁶/°C et 100.10⁻⁶/°C, et de façon plus préférentielle entre 5.10⁻⁶/°C et 50.10⁻⁶/°C.

Le dit intercalaire 6 doit en outre présenter une excellente inertie chimique sur une large gamme de température, sa température limite d'utilisation pouvant monter, jusqu'à 80 °C en continu.

Suivant une forme de réalisation préférée, l'intercalaire est une couche polymérique 6 présentant des propriétés « élastiques » (par exemple un élastomère) ou « viscoélastique » supportant de très grandes déformations avant rupture.

L'intercalaire 6 choisi n'est pas forcement un matériau commercial prêt à l'emploi, il peut être formé chimiquement in situ afin de répondre aux exigences mentionnées ci-dessus.

On a songé à utiliser plus particulièrement, au sein de la gamme des polymères répondant à ces critères mécaniques, un matériau de liaison inattendu, à savoir une couche de poly(butyral de vinyle) 6, un polymère utilisé d'habitude essentiellement en raison de sa transparence pour la fabrication de pare-brises ou de verre blindé. Il s'agit d'un usage paradoxal, étant donné que ses qualités optiques n'ont ici strictement aucune importance, et que de surcroît il est utilisé non pas pour lier des couches de verre (où la question du différentiel de coefficient de dilatation ne se pose évidemment pas), mais entre un métal et un diélectrique. Paradoxalement, les essais se sont montrés concluants, si ce n'est que le poly(butyral de vinyle) est totalement incompatible avec la gamme de température rencontrée dans une chambre plasma. Il faut savoir que les températures atteintes au sein d'un plasma sont facilement d'au moins 200°C, typiquement entre 200°C et 600°C. On a donc dû développer une technologie particulière permettant de limiter l'élévation de la température dans la couche de liaison 6.

Le corps de l'électrode, dont fait partie la surface plane 2, est creux et constitue une enveloppe fermée 8 au sein de laquelle circule un fluide de réfrigérant 10, constituant ainsi le premier échangeur de chaleur 2,8. Ce fluide de refroidissement pénètre dans l'électrode 1 par un conduit d'entrée 12 et en ressort par un conduit de sortie 14. L'enveloppe 8 est munie de moyens favorisant la dissipation de chaleur vers le fluide de refroidissement 10, tels que des chicanes 16. Il s'agit par ailleurs de ne pas entraver la circulation rapide du fluide de refroidissement 10, étant donné qu'on vise à obtenir une dissipation de l'ordre de 30W/cm² sur toute la surface de l'électrode 1.

L'épaisseur de la couche de poly(butyral de vinyle) 6 (exagérée dans le dessin) est calculée de façon à reprendre sans problème les sollicitations dues à la différence de coefficient d'allongement entre les deux surfaces assemblées. Par ailleurs, on ne peut interposer une couche trop épaisse, qui ralentirait le passage de l'énergie thermique vers le circuit de refroidissement et celle de l'énergie électrique vers le plasma. On obtient un bon compromis avec une épaisseur de l'ordre de 0.7 mm.

Une technologie particulière a dû être développée pour éviter la présence de bulles de gaz dans la couche de liaison 6. La présence de bulles risque en effet d'entraîner des claquages au sein même de la couche de liaison. L'assemblage se déroule donc de manière suivante : l'électrode étant placée dans une enceinte hermétique, après avoir posé une feuille de poly(butyral de vinyl) sur la face extérieure de la partie plane et avoir recouvert celle-ci d'une plaque de matériau diélectrique, on chauffe l'électrode jusqu'à ramollissement de la feuille de poly(butyral de vinyl). L'enceinte est ensuite mise en dépression de façon à favoriser le dégazage de la feuille de PVB. De minuscules bulles de gaz emprisonnées migrent ainsi dans le polymère visqueux vers l'extérieur, où elles sont éliminées, jusqu'à leur totale disparition. L'enceinte est ensuite mise sous pression pour réaliser une précontrainte et un contact intime entre les composants assemblés, qui sont finalement refroidis.

Comme signalé plus haut, on a tout avantage à ce que l'électrode puisse évacuer aussi rapidement que possible l'énergie thermique qui lui est transmise à partir du plasma. En conséquence, elle a tout intérêt à être d'un seul tenant. Ceci n'exclut cependant pas un mode de réalisation par assemblage de sa face active 2 et de l'enveloppe hermétique 8 jouant le rôle d'échangeur thermique (2,8).

L'électrode 1 étant assemblée, il reste à l'intégrer au sein d'une installation de génération de plasma, où elle est censée être portée à une très haute tension. Afin d'éviter une inégalité de la répartition de la tension, l'électrode est alimentée via une connexion « en râteau » 18, qui met en parallèle les différentes zones de l'électrode. D'autre part, le refroidissement, rendu obligatoire par l'utilisation de PVB, entraîne la nécessité de faire circuler un fluide caloporteur porté à très haute tension, de l'ordre typiquement de 40.000 Volts. Ceci implique classiquement l'intégration dans l'installation d'un échangeur de chaleur isolé par rapport à la masse, d'où une complexification des circuits d'échange et une importante perte de place, et en conséquence une multiplication des risques d'accident. On a donc cherché à mettre au point un système plus simple et potentiellement moins dangereux. Plutôt que pour une isolation à outrance, on a opté pour l'interposition d'une résistance de valeur élevée entre l'électrode et la masse, de façon à ce que le courant de fuite qui en résulte prenne une valeur négligeable. On utilise donc un fluide caloporteur paradoxal mais présentant toute une série d'avantages physiques : l'eau pure. L'eau faiblement chargée en minéraux est en effet un fluide remarquablement mauvais conducteur. Cette eau est amenée jusqu'à l'électrode et repart de celle-ci par deux longs conduits 20 et 22 en matériaux polymères, intrinsèquement isolants.

La résistance nécessaire est calculée en appliquant la formule R= ρ. l/s, dans laquelle
ρ = 10⁹ Ωm (résistivité de l'eau distillée)
I(m)= longueur de chaque conduit
s (m²)= section de chaque conduit

On obtient donc une résistance appropriée, limitant les courants de fuite à une valeur tolérable, en prévoyant une longueur suffisante et une section appropriée des conduits 20 et 22.

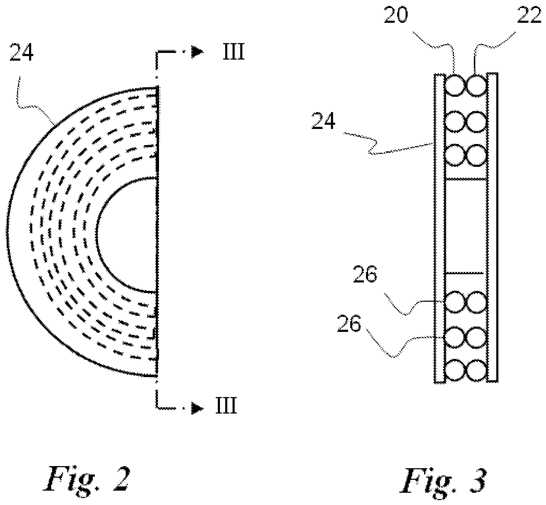

Le problème d'encombrement de ces conduits est résolu en les enroulant sur un tambour 24, tel que représenté schématiquement aux Fig. 2 et 3.

Pour éviter les courts-circuits entre les deux conduits 20 et 22, entre leurs propres spires ou entre leurs spires respectives, les deux conduits 20 et 22 ont une longueur identique et sont enroulés côte à côte, de façon à obtenir entre eux un ΔV proche de zéro. Par ailleurs, le ΔV entre deux spires 26 consécutives est toujours extrêmement réduit. De la sorte, lorsqu'on en arrive à l'extrémité des deux conduits, ils peuvent être reliés sans danger à la masse constituée par un échangeur de chaleur classique, leur différence de potentiel par rapport à celle-ci étant à ce moment proche de zéro.

La Fig. 4 montre schématiquement l'électrode montée au sein d'une installation DBD.

L'électrode 1 est placée en vis-à-vis d'un substrat à traiter 27. Les conduits d'entrée 12 et de sortie 14 du circuit de refroidissement secondaire 34, au sortir du tambour d'enroulement 24, sont mis à la terre (engendrant un courant de fuite négligeable) et sont reliés au second échangeur de chaleur 28. Le circuit de refroidissement primaire 32 de cet échangeur 28 est relié à un groupe de production de froid 30, le circuit de refroidissement secondaire 34 de cet échangeur 28 étant relié à l'électrode 1, via le tambour 24.

L'électrode 1 elle-même est reliée à un des pôles d'un circuit Haute Tension (et Haute Fréquence), l'autre pôle étant connecté à une contre-électrode 36, elle-même mise à la terre.

Il apparaîtra évident pour l'homme du métier que la présente invention n'est pas limités aux exemples illustrés et décrits ci-dessus. L'invention comprend chacune des caractéristiques nouvelles ainsi que leur combinaison. La présence de numéros de référence ne peut être considérée comme limitative. L'usage du terme « comprend » ne peut en aucune façon exclure la présence d'autres éléments autres que ceux mentionnés. L'usage de l'article défini « un » pour introduire un élément n'exclut pas la présence d'une pluralité de ces éléments. La présente invention a été décrite en relation avec des modes de réalisations spécifiques, l'invention est définie par les revendications.

## Revendications

1. Electrode plane (1) pour traitement plasma DBD de surfaces, ladite électrode (1), destinée à être portée à haute tension, comprenant une enveloppe métallique (8), ladite enveloppe (8) comprenant une partie active (2) apte à être disposée parallèlement à une surface à traiter (27), ladite partie active (2) étant recouverte extérieurement d'une plaque de matériau diélectrique (4), la plaque de matériau diélectrique (4) étant fixée à la partie active (2) par une couche polymérique intercalaire (6), ladite électrode (1) étant **caractérisée en ce que** la couche polymérique intercalaire (6) est constituée d'un matériau choisi parmi les EVA [Acétate d'éthylène-vinyle] et les PVB [poly(butyral de vinyle)] ladite couche polymérique intercalaire étant déposée sous forme d'une feuille.

2. Electrode selon la revendication 1, dans laquelle une face interne de la partie active (2) forme avec l'enveloppe métallique (8) un échangeur de chaleur (2,8).

3. Electrode selon la revendication 2, dans laquelle l'échangeur de chaleur (2,8) est adapté à être relié à un circuit de refroidissement (34) dans lequel circule un fluide caloporteur (10).

4. Electrode selon l'une des revendications 1 à 3, dans laquelle la couche polymérique intercalaire (6) présente un taux d'allongement avant déchirure compatible avec un différentiel de coefficient linéaire d'expansion thermique compris, pour une gamme de température de 0 à 100°C, entre 0.01 10⁻⁶/°C et 1000.10⁻⁶/°C.

5. Electrode selon l'une des revendications 1 à 4, dans laquelle le matériau de la couche polymérique intercalaire (6) est choisi au sein du groupe des EVA [Acétate d'éthylène-vinyle)].

6. Electrode selon l'une des revendications 1 à 4, , dans laquelle la couche polymérique intercalaire (6) est en PVB [poly(butyral de vinyle)].

7. Electrode selon l'une quelconque des revendications 1 à 6, dans laquelle le fluide caloporteur est de l'eau, avantageusement faiblement minéralisée de façon à constituer un fluide de faible conductivité.

8. Electrode selon l'une quelconque des revendications 1 à 7, dans laquelle l'enveloppe métallique (8) est réalisée en un matériau présentant à la fois un coefficient de conductivité électrique compris entre 1 et 80 m/(Ωmm²) et un coefficient de conductibilité thermique compris 50 et 400 W/(mK).

9. Electrode selon la revendication 8, dans laquelle le matériau métallique est du cuivre.

10. Dispositif comprenant une électrode plane (1) pour traitement plasma DBD de surfaces selon l'une des revendications précédentes et au moins un circuit de refroidissement (34), laquelle électrode est reliée à l'au moins un circuit de refroidissement (34), une face interne de la partie active (2) formant avec l'enveloppe métallique (8) un échangeur de chaleur (2,8) relié à l'au moins un circuit de refroidissement (34) lequel est apte à y faire circuler un fluide caloporteur (10).

11. Dispositif selon la revendication 10, dans lequel l'électrode est reliée à deux circuits de refroidissements primaire (32) et secondaire (34) munis respectivement d'un premier (2,8) et d'un second échangeurs de chaleurs (28), le second échangeur de chaleur (28) relie le circuit de refroidissement primaire (32) au circuit de refroidissement secondaire (34) par l'intermédiaire de conduits (20,22) en matériau à faible conductivité électrique, la longueur et la section de ces conduits (20,22) étant calculées de telle manière que ces conduits (20,22) constituent une résistance d'isolement suffisante pour que ce second échangeur de chaleur (28) puisse être mis à la terre en n'engendrant qu'un courant de fuite négligeable.

12. Dispositif selon la revendication 11, dans lequel les conduits aller (20) et retour (22) du circuit de refroidissement secondaire (34) sont enroulés sur un tambour (24).

13. Dispositif selon la revendication 12, dans lequel les conduits aller (20) et retour (22) du circuit de refroidissement secondaire (34) sont placés côte à côte sur le tambour (24).

14. Dispositif selon l'une quelconque des revendications 10 à 13, dans lequel le circuit de refroidissement secondaire (34) comprend un système de contrôle (38) apte à mesurer périodiquement la conductivité du fluide de caloporteur (10).

## Patentansprüche

1. Planare Elektrode (1) zur Plasma-DBD-Oberflächenbehandlung, wobei die Elektrode (1), die dazu bestimmt ist, auf Hochspannung gebracht zu werden, ein Metallgehäuse (8) umfasst, wobei das Gehäuse (8) ein Aktivteil (2) umfasst, das parallel zu einerzu behandelnden Oberfläche (27) angeordnet werden kann, wobei das Aktivteil (2) von außen mit einer Platte aus dielektrischem Material (4) bedeckt ist, wobei die Platte aus dielektrischem Material (4) durch eine polymere Zwischenschicht (6) an dem Aktivteil (2) befestigt ist, wobei die Elektrode (1) **dadurch gekennzeichnet ist, dass** die polymere Zwischenschicht (6) aus einem Material besteht, das aus EVA [Ethylenvinylacetat] und PVB [Poly(vinylbutyral)] ausgewählt ist, wobei die polymere Zwischenschicht in Form eines Blatts aufgetragen wird.

2. Elektrode nach Anspruch 1, wobei eine Innenfläche des Aktivteils (2) zusammen mit dem Metallgehäuse (8) einen Wärmetauscher (2, 8) bildet.

3. Elektrode nach Anspruch 2, wobei der Wärmetauscher (2, 8) so ausgelegt ist, dass er an einen Kühlkreislauf (34) angeschlossen werden kann, in dem ein Kühlmittel (10) zirkuliert.

4. Elektrode nach einem der Ansprüche 1 bis 3, wobei die polymere Zwischenschicht (6) eine Dehnungsrate vor dem Zerreißen aufweist, die mit unterschiedlichen linearen Wärmeausdehnungskoeffizienten kompatibel ist, die für einen Temperaturbereich von 0 bis 100 °C zwischen 0,01 · 10-6/ °C und 1000 · 10-6/ °C liegen.

5. Elektrode nach einem der Ansprüche 1 bis 4, wobei das Material der polymeren Zwischenschicht (6) aus der Gruppe der EVA [Ethylenvinylacetat] ausgewählt ist.

6. Elektrode nach einem der Ansprüche 1 bis 4, wobei die polymere Zwischenschicht (6) aus PVB [Poly(vinylbutyral)] besteht.

7. Elektrode nach einem der Ansprüche 1 bis 6, wobei es sich bei dem Kühlmittel um Wasser handelt, das bevorzugt leicht mineralisiert ist, sodass ein Fluid mit niedriger Leitfähigkeit gebildet wird.

8. Elektrode nach einem der Ansprüche 1 bis 7, wobei das Metallgehäuse (8) aus einem Material hergestellt ist, das sowohl einen elektrischen Leitfähigkeitskoeffizienten zwischen 1 und 80 m/(Ωmm²) als auch einen Wärmeleitfähigkeitskoeffizienten zwischen 50 und 400 W/(mK) aufweist.

9. Elektrode nach Anspruch 8, wobei das metallische Material Kupfer ist.

10. Vorrichtung, umfassend eine planare Elektrode (1) zur Plasma-DBD-Oberflächenbehandlung nach einem der vorangehenden Ansprüche und mindestens einen Kühlkreislauf (34), wobei die Elektrode mit dem mindestens einen Kühlkreislauf (34) verbunden ist, wobei eine Innenfläche des Aktivteils (2) zusammen mit dem Metallgehäuse (8) einen Wärmetauscher (2, 8) bildet, der mit dem mindestens einen Kühlkreislauf (34) verbunden ist, der in der Lage ist, ein Kühlmittel (10) darin zirkulieren zu lassen.

11. Vorrichtung nach Anspruch 10, bei der die Elektrode mit zwei Kühlkreisläufen, einem primären (32) und einem sekundären (34), verbunden ist, die jeweils mit einem ersten (2, 8) und einem zweiten Wärmetauscher (28) versehen sind, wobei der zweite Wärmetauscher (28) den primären Kühlkreislauf (32) mit dem sekundären Kühlkreislauf (34) über Kanäle (20, 22) verbindet, die aus einem Material mit niedriger elektrischer Leitfähigkeit hergestellt sind, wobei Länge und Querschnitt dieser Kanäle (20, 22) so berechnet sind, dass die Kanäle (20, 22) einen ausreichenden Isolationswiderstand aufweisen, damit dieser zweite Wärmetauscher (28) mit vernachlässigbarem Ableitstrom geerdet werden kann.

12. Vorrichtung nach Anspruch 11, wobei die Vor- (20) und Rücklaufkanäle (22) des sekundären Kühlkreislaufs (34) auf einer Trommel (24) aufgewickelt sind.

13. Vorrichtung nach Anspruch 12, wobei die Vor- (20) und Rücklaufkanäle (22) des sekundären Kühlkreislaufs (34) nebeneinander auf der Trommel (24) angeordnet sind.

14. Vorrichtung nach einem der Ansprüche 10 bis 13, wobei der sekundäre Kühlkreislauf (34) ein Steuerungssystem (38) umfasst, das geeignet ist, die Leitfähigkeit des Kühlmittels (10) periodisch zu messen.

## Claims

1. Planar electrode (1) for DBD plasma treatment of surfaces, said electrode (1) being intended to be raised to a high voltage and comprising a metal envelope (8), said envelope (8) comprising an active part (2) able to be placed parallel to a surface (27) to be treated, said active part (2) being covered on the outside by a dielectric sheet (4), the dielectric sheet (4) being fixed to the active part (2) by a polymer interlayer (6), said electrode (1) being **characterized in that** the polymer interlayer (6) is made of a material chosen from EVA (ethylene vinyl acetate) and PVB (polyvinyl butyral), said polymer interlayer being deposited in the form of a film.

2. Electrode according to Claim 1, in which an internal side of the active part (2) forms a heat exchanger (2, 8) with the metal envelope (8).

3. Electrode according to Claim 2, in which the heat exchanger (2, 8) is designed to be connected to a cooling circuit (34) in which a heat-transfer fluid (10) flows.

4. Electrode according to one of Claims 1 to 3, in which the polymer interlayer (6) has an elongation at break compatible with a linear thermal expansion coefficient differential of, for a temperature range of 0 to 100oC, between 0.01×10-6/oC and 1000×10-6/oC.

5. Electrode according to one of Claims 1 to 4, in which the material of the polymer interlayer (6) is chosen from the group of EVA (ethylene vinyl acetate).

6. Electrode according to one of Claims 1 to 4, in which the polymer interlayer (6) is made of PVB (polyvinyl butyral).

7. Electrode according to any one of Claims 1 to 6, in which the heat-transfer fluid is water, advantageously with a low mineral content in order for the fluid to have a low conductivity.

8. Electrode according to any one of Claims 1 to 7, in which the metal envelope (8) is made of a metal having both an electrical conductivity of between 1 and 80 m/(Ωmm²) and a thermal conductivity of between 50 and 400 W/(mK).

9. Electrode according to Claim 8, in which the metal is copper.

10. Device comprising a planar electrode (1) for DBD plasma treatment of surfaces according to one of the preceding claims and at least one routing circuit (34), which electrode is connected to at least one cooling circuit (34), an internal side of the active part (2) forming a heat exchanger (2, 8) with the metal envelope (8), the heat exchanger being connected to the at least one cooling circuit (34) which is capable of having a heat-transfer fluid (10) flow therein.

11. Device according to Claim 10, in which the electrode is connected to two cooling circuits, a primary cooling circuit (32) and a secondary cooling circuit (34), respectively equipped with a first heat exchanger (2,8) and a second heat exchanger (28), the second heat exchanger (28) connecting the primary cooling circuit (32) to the secondary cooling circuit (34) via ducts (20, 22) made of a material with a low electrical conductivity, the length and the cross section of these ducts (20, 22) being calculated to be such that the insulation resistance of these ducts (20, 22) is high enough that grounding the second heat exchanger (28) causes only a negligible leakage current.

12. Device according to Claim 11, in which the supply (20) and return (22) ducts of the secondary cooling circuit (34) are wound around a drum (24).

13. Device according to Claim 12, in which the supply (20) and return (22) ducts of the secondary cooling circuit (34) are placed side-by-side on the drum (24).

14. Device according to any one of Claims 10 to 13, in which the secondary cooling circuit (34) comprises a control system (38) that is able to periodically measure the conductivity of the heat-transfer fluid (10).
